# EUROPEAN PATENT APPLICATION

(11) **EP 4 852 647 A1**
(43) Date of publication of application: **09.12.2026**
(21) Application number: 25219747.0
(22) Date of filing: 01.12.2025
(51) Int. Cl.: H10D 64/23, H10W 20/42, H10W 20/40, H10D 30/01, H10D 84/83, H10D 62/10, B82Y 10/00, H10D 62/13

(54) **SOURCE/DRAIN ENGINEERING FOR NANORIBBON-BASED TRANSISTORS**

(30) Priority: 03.06.2025 US 202519227220
(71) Applicant: Intel Corporation, Santa Clara, CA 95054 (US)
(72) Inventor: YEONG, Sai Hooi, Cupertino 95014 (US); BOUCHE, Guillaume, Portland 97217 (US); FROST, Denzil, Albuquerque 87114 (US)
(74) Representative: Viering, Jentschura & Partner mbB Patent- und Rechtsanwälte

(57) **Abstract**

Source/drain engineering techniques, as described in the examples herein, may improve access resistance between a bottom nanoribbon and a source or drain region. In one example an S/D opening is formed in a nanoribbon stack. A sacrificial material is deposited at the bottom of the opening. The doped semiconductor material may then be provided over the sacrificial material (for example with an epitaxial deposition process). The sacrificial material may then be removed in a subsequent process from the back side of the IC structure and a doped semiconductor material may be provided from the back side. In one such example, a nucleation layer is absent in the region where the sacrificial material was removed.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 is a flow diagram of an example method for fabricating an IC structure using source/drain engineering techniques for nanoribbon-based transistors, according to some embodiments of the present disclosure.
FIGS. 3A-3D provide cross-sectional side views at various stages in the fabrication of an example IC structure according to the method of FIG. 2, in accordance with some embodiments.
FIGS. 4-6 illustrate cross-sectional side view of different examples of IC structures fabricated using source/drain engineering techniques for nanoribbon-based transistors, in accordance with some embodiments.
FIG. 7 illustrates a different cross-sectional side view of an IC structure fabricated using source/drain engineering techniques for nanoribbon-based transistors, in accordance with some embodiments.
FIG. 8 is a top view of a wafer and dies that may include any of the IC structures disclosed herein, in accordance with any of the embodiments disclosed herein.
FIG. 9 is a side, cross-sectional view of an IC device that may include any of the IC structures disclosed herein, in accordance with any of the embodiments disclosed herein.
FIG. 10 is a side, cross-sectional view of an IC package that may include any of the IC structures disclosed herein, in accordance with various embodiments.
FIG. 11 is a side, cross-sectional view of an IC device assembly that may include any of the IC structures disclosed herein, in accordance with any of the embodiments disclosed herein.
FIG. 12 is a block diagram of an example electrical device that may include any of the IC structures disclosed herein, in accordance with any of the embodiments disclosed herein.

### Detailed Description

Disclosed herein are integrated circuit (IC) structures fabricated using source/drain engineering techniques for nanoribbon-based transistors. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

In nanoribbon-based transistor architectures, the resistance between the channel and the source or drain contact regions (S/D regions) may be higher in the bottom nanoribbons than in the top nanoribbons. One factor contributing to this resistance is a nucleation layer provided on the sidewalls of a S/D opening, which facilitates the epitaxial growth of the doped semiconductor material in the source or drain region. The high access resistance at the bottom nanoribbons can negatively impact device performance, for example, by reducing the drive in the transistor.

Source/drain engineering techniques, as described in the examples herein, may improve access resistance between a bottom nanoribbon and a source or drain contact region. In one example an S/D opening is formed in a nanoribbon stack. A sacrificial material is deposited at the bottom of the opening. The doped semiconductor material may then be provided over the sacrificial material (for example with an epitaxial deposition process). The sacrificial material may then be removed in a subsequent process from the back side of the IC structure and a doped semiconductor material may be provided from the back side. In one such example, a nucleation layer is absent in the region where the sacrificial material was removed. The absence of the nucleation layer between the bottom nanoribbon(s) and the doped semiconductor material of the S/D region enables a less resistive path, which may increase drive and improve device performance.

IC structures as described herein, in particular IC structures fabricated using source/drain engineering techniques for nanoribbon-based transistors as described herein, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures fabricated using source/drain engineering techniques for nanoribbon-based transistors as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices (e.g., physically coupled, conductively coupled, e.g., directly electrically connected). A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

IC structures fabricated using source/drain engineering techniques may include transistors of various architectures (e.g., non-planar transistor architectures). Non-planar transistors such as double-gate transistors, trigate transistors, FinFETs, nanowire, and nanoribbon transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

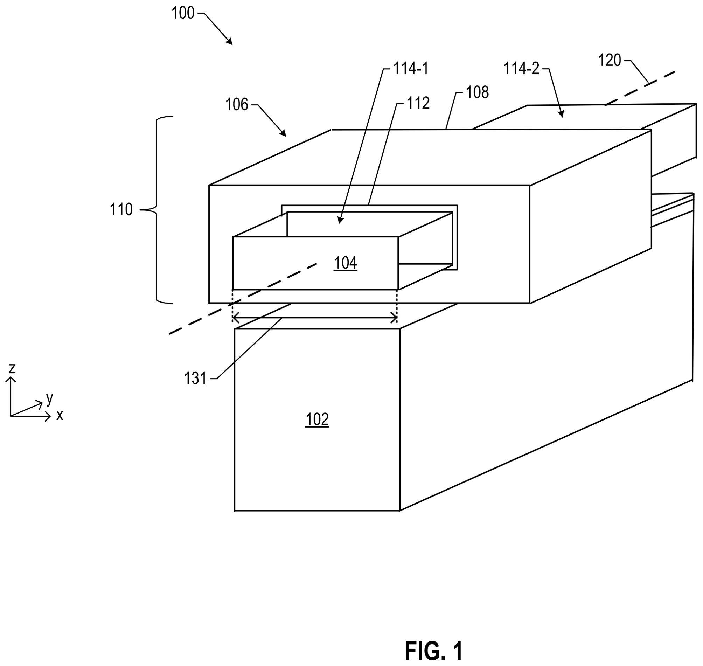

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 1, 3A-3D, and 4-7), although IC structures fabricated using source/drain engineering techniques described herein may include other devices instead of or in addition to nanoribbon-based transistors and are not limited to such transistors.

As used herein, the term "nanoribbon" refers to an elongated semiconductor structure having a long axis parallel to a support structure (e.g., a substrate, a chip, or a wafer) over which a transistor arrangement is provided. In some settings, the term "nanoribbon" has been used to describe an elongated semiconductor structure that has a rectangular transverse cross-section (i.e., a cross-section in a plane perpendicular to the longitudinal axis of the structure), while the term "nanowire" has been used to describe a similar structure but with a circular or square-like transverse cross-section. In the present disclosure, the term "nanoribbon" is used to describe both such nanoribbons (including nanosheets) and nanowires, as well as elongated semiconductor structures with a longitudinal axis parallel to the support structures and with having transverse cross-sections of any geometry (e.g., oval, or a polygon with rounded corners). As used herein, the term "face of a nanoribbon" refers to any of the confinement surfaces (i.e., interfaces of the semiconductor material of the nanoribbon with the gate stack) of the nanoribbon which are substantially parallel to the support structure when a nanoribbon extends in a direction parallel to the support structure, while the term "sidewall of a nanoribbon" refers to any of the confinement surfaces of the nanoribbon connecting the bottom face and the top face (the bottom face being the face of the nanoribbon that is closer to the support structure than the top face).

Another example of a nanoribbon-based transistor architecture is a nanocomb transistor architecture (also sometimes referred to as a forksheet architecture), where the name "nanocomb/forksheet" arises because of its complex bilateral finned structure. In an example nanocomb transistor arrangement, the nanoribbons are coupled with a dielectric "spine" or wall, and there is no gate enclosure on one of the two sides of the vertical stack of lateral nanoribbons or nanosheets (referred to in the following as "nanoribbons"), while the gate enclosure on the other side still remains. In other examples, a nanocomb transistor arrangement may include a portion of the gate electrode material and/or gate insulator between the dielectric spine and the nanoribbons.

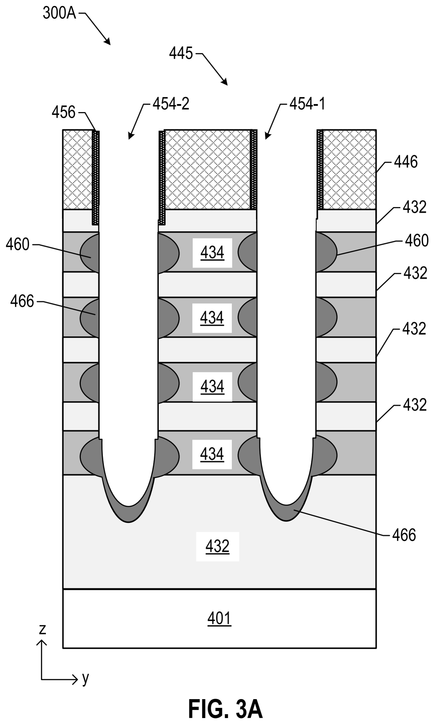

FIG. 1 provides a perspective view of an example IC structure 100 with a nanoribbon transistor 110, according to some embodiments of the present disclosure. For example, in various embodiments, the transistor 110 formed on the basis of a nanoribbon 104, shown in FIG. 1, may be formed on the basis of any of the nanoribbon-based transistor arrangements shown in any of FIGS. 3A-3D and 4-7. In some of those examples, the nanoribbon-based transistor arrangement is a nanocomb transistor that is formed in the stacks of lateral nanoribbons separated by a dielectric wall. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

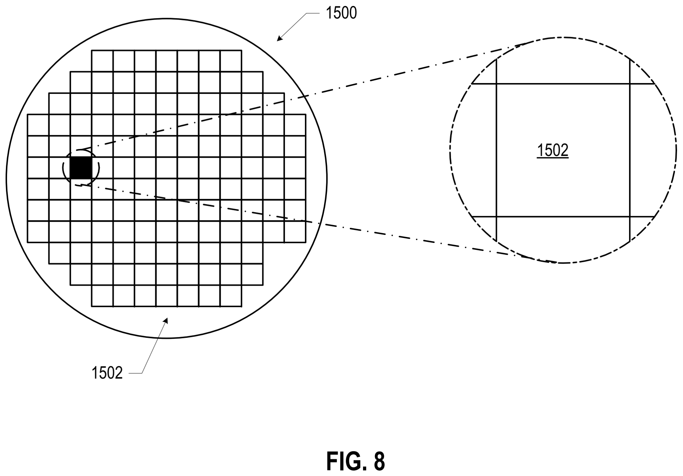

Implementations of the present disclosure may be formed or carried out on any suitable support 102, such as a substrate, a die, a wafer, or a chip. The support 102 may, e.g., be the wafer 1500 of FIG. 8, discussed below, and may be, or be included in, a die, e.g., the singulated die 1502 of FIG. 8, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure fabricated using source/drain engineering techniques for nanoribbon-based transistors as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIGS. 3A-3D and 4-6 show IC structures that may be or include examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width 131 of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some examples, nanoribbons of the same semiconductor material may be used to form NMOS and PMOS transistors. In such examples, the NMOS and PMOS transistors may be differentiated by depositing N-type or P-type work function metals around channel portions of those transistors.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, Nor P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., frontend components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided below.

Turning to the S/D regions 114-1, 114-2 of the transistor 110, if the transistor 110 is an N-type transistor, the S/D regions 114-1, 114-2 may be doped with N-type dopants to create regions with an excess of electrons that can serve as the majority charge carriers during operation of the transistor 110. In an N-type transistor the channel region may be lightly doped with N-type dopants or may be an undoped/intrinsic semiconductor material. If the transistor 110 is a P-type transistor, the S/D regions 114-1, 114-2 may be doped with P-type dopants to create regions with an excess of holes that can serve as the majority charge carriers during operation of the transistor 110. In a P-type transistor the channel region may be lightly doped with P-type dopants or may be an undoped/intrinsic semiconductor material. For both N-type and P-type transistors, in some embodiments, the S/D regions may be doped with dopant concentrations of at least 10¹⁷ dopants per cubic cm (cm⁻³), or more, e.g., with dopant concentrations of at least 10¹⁸ cm⁻³ or with dopant concentrations of at least 10²⁰ cm⁻³. In some embodiments, the S/D regions 114-1, 114-2 may be heavily doped, e.g., with dopant concentrations of at least about 10²⁰ or at least about 10²¹ cm⁻³, in order to advantageously form Ohmic contacts with the respective S/D contacts, although these regions may also have lower dopant concentrations and may form Schottky contacts in some implementations. Irrespective of the exact doping levels, the S/D regions 114-1, 114-2 may be the regions having dopant concentration higher than in other regions of the transistor 110, e.g., higher than a dopant concentration in the channel region (e.g., in a portion of the channel material extending between the first S/D region 114-1 and the second S/D region 114-2). Therefore, the S/D regions 114-1, 114-2 may be referred to as "highly doped" (HD) regions of the transistor 110. The channel region of the transistor 110 may include semiconductor materials with doping concentrations significantly smaller than those of the S/D regions 114-1, 114-2. In some embodiments, a lightly doped channel region of the transistor 110 may have dopant concentrations between about 10¹⁴ cm⁻³ and about 10¹⁷ cm⁻³ or 0.5x10¹⁷ cm⁻³, while an undoped/intrinsic channel region of the transistor 110 may have dopant concentrations below about 10¹³ cm⁻³, e.g., below 10¹² cm⁻³.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1, 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

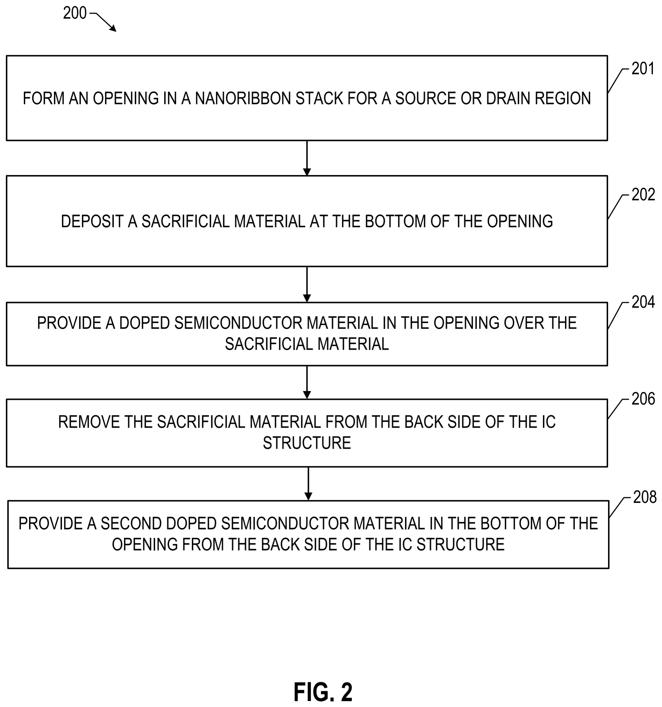

FIG. 2 is a flow diagram of an example method 200 for fabricating an IC structure using source/drain engineering techniques for nanoribbon-based transistors. FIGS. 3A-3D provide different views at various stages in the fabrication of an example IC structure according to the method of FIG. 2, in accordance with some embodiments. Although the operations of the method of FIG. 2 are illustrated once each and in a particular order, the operations may be performed in any suitable order and repeated as desired. For example, one or more operations may be performed in parallel to fabricate multiple IC structures using source/drain engineering techniques for nanoribbon-based transistors substantially simultaneously. In another example, the operations may be performed in a different order to reflect the structure in which source/drain engineering techniques will be implemented.

In addition, the example fabricating method of FIG. 2 may include other operations not specifically shown in FIG. 2, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIG. 2 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 2, the method 200 begins with a process 201 of forming an opening in a nanoribbon stack for an S/D region. The IC structure 300A of FIG. 3A is an example of an IC structure resulting from the process 201.

The IC structure 300A, as illustrated in FIG. 3A, includes a stack of alternating layers of materials 432 and 434 over a substrate 401. The stack includes multiple layers of a semiconductor material 432 and another material 434, arranged alternately. This configuration may begin with a bottom layer of the semiconductor material 432 provided over the substrate 401.

The semiconductor material 432 may be any suitable semiconductor/channel material, such as silicon or silicon germanium, while the material 434 may be a second semiconductor material or an insulator material that is etch-selective with respect to the semiconductor material 432. This etch-selectivity allows the material 434 to be selectively etched away in later processes to form nanoribbons of the semiconductor material 432. A material 446, which may be referred to as the dummy gate or replacement gate, may be present over and around a fin patterned from the stack. In one example, the material 446 may be any suitable material such as polysilicon.

The IC structure 300A features S/D openings 454-1 and 454-2 formed in the stack from a side 445 (e.g., the front side) of the IC structure 300A. The openings 454-1 and 454-2 may be formed using any suitable etching techniques, such as a dry etch technique, e.g., RF reactive ion etch (RIE) or inductively coupled plasma (ICP) RIE. The first opening 454-1 may subsequently be formed into a drain region of a transistor, while the second opening 454-2 may be formed into a source region of the transistor, or vice versa.

Additionally, in some embodiments, portions of the openings 454-1, 454-2 surrounded by the dummy gate material 446 may be lined with a liner 456, which may include a plurality of different liners even though it is shown in FIG. 3A as a single liner 456. The liner 456 may include one or more of spacer materials, diffusion barrier materials, adhesion materials, etc., as known in the art for forming contacts to various components of IC structures.

In the example shown in FIG. 3A, the material 434 in the S/D openings 454-1, 454-2 is recessed, resulting in the formation of dimples 460. These dimples are areas where the material 434 has been laterally recessed from the original sidewalls of the openings 454-1, 454-2. The dimples 460 may be filled with a spacer material 466. Furthermore, the spacer material 466 may also line bottoms of the openings 454-1, 454-2. In one such example, the spacer material 466 lines the subfin portion of the fin. The spacer material 466 may include any suitable insulator material and be provided using any suitable deposition technique. In one such example, the dimples 460 provide electrical insulation between the material of the S/D regions formed within the openings 454-1, 454-2 and the gate electrode material that will be present between the nanoribbons of the semiconductor material 432.

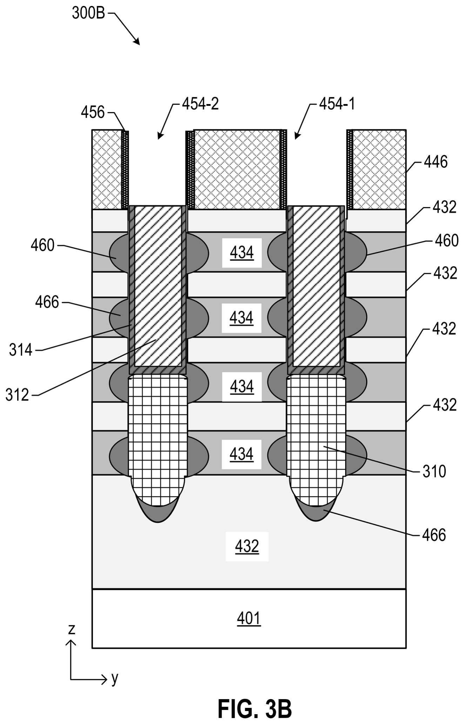

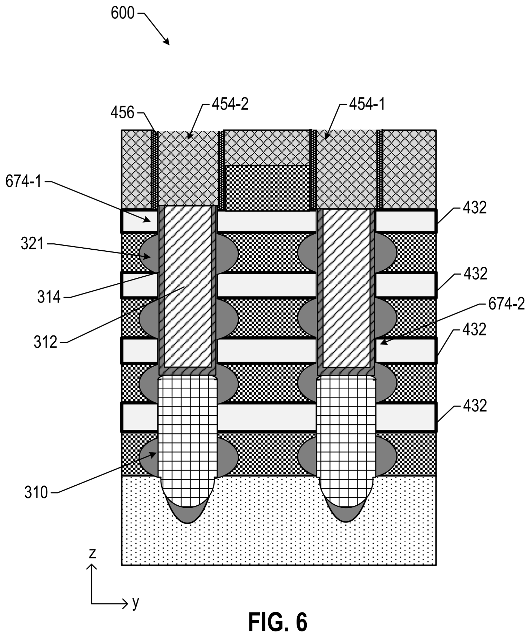

The method 200 continues with a process 202 of depositing a sacrificial material at a bottom of the opening and a process 204 of providing a doped semiconductor material in the opening over the sacrificial material. The IC structure 300B of FIG. 3B is an example of an IC structure resulting from the processes 202 and 204. As can be seen in FIG. 3B, the IC structure 300B includes a sacrificial material 310 at the bottom of the openings 454-1, 454-2. The sacrificial material 310 may be any suitable sacrificial material that may be removed from the back side of the IC structure 300B in a subsequent process, and may be deposited using any suitable deposition technique (e.g., chemical vapor deposition (CVD), atomic layer deposition (ALD), etc.). In some examples, the sacrificial material 310 may be an insulator material, such as silicon oxide (e.g., an insulator material that includes silicon and oxygen), silicon nitride (e.g., an insulator material that includes silicon and nitrogen), or another suitable insulator material. According to examples, the spacer material 466 is etch-selective with respect to the sacrificial material 310 so that etchants used to etch the sacrificial material 310 do not substantially etch the spacer material 466, allowing for selective etching of the sacrificial material 310 while preserving the spacer material 466. In some examples, the sacrificial material 310 may not be removed from the S/D openings of some transistors in order to control the drive strength of transistors relative to one another, as discussed in more detail below with respect to FIG. 6.

The doped semiconductor material 312 may be deposited using any suitable technique, and may be an example of a doped semiconductor material discussed above with respect to the S/D regions 114-1 and 114-2. In the example shown in FIG. 3B, the doped semiconductor material 312 is epitaxially grown on a nucleation layer 314 of semiconductor material. In some examples, the nucleation layer 314 may have a thickness in a range of about 1 to 10 nanometers. The nucleation layer 314 and the doped semiconductor material 312 may have one or more different properties, such as dopant concentration and/or defect concentration. In one such example, the doped semiconductor material 312 has a higher dopant concentration than the nucleation layer 314.

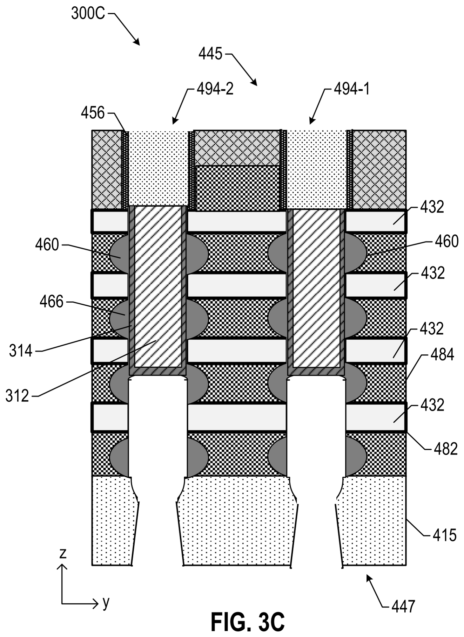

The method 200 continues with a process 206 of removing the sacrificial material from the back side of the IC structure. The IC structure 300C of FIG. 3C is an example of an IC structure 300C resulting from the process 206. As can be seen in FIG. 3C, additional processing may be performed after providing the doped semiconductor material 312 and before removing the sacrificial material 310. For example, after providing the doped semiconductor material 312 in the S/D openings 454-1, 454-2, the method may involve: removing the material 434 to release nanoribbons of the semiconductor material 432, providing a gate dielectric material 482 around channel portions of the nanoribbons, providing a gate electrode material 484 around the gate dielectric material 482, and forming S/D contact structures 494-1, 494-2 over the doped semiconductor material 312 of the S/D regions. Additionally, the substrate 401 may be thinned and/or removed. In one example, the semiconductor material 432 (e.g., the layer of semiconductor material 432 that was under the stack of nanoribbons) may be removed and replaced with an insulator material 415. The insulator material 415 may include, for example, one or more of silicon, oxygen, nitrogen, carbon, and boron. In another example, the insulator material 415 may include aluminum and nitrogen (e.g., AIN). According to examples, the insulator material 415 is etch-selective with respect to the sacrificial material 310 so that etchants used to etch the sacrificial material 310 do not substantially etch the insulator material 415, allowing for selective etching of the sacrificial material 310 while preserving the insulator material 415. As mentioned above, the insulator material 415 may also be etch selective with respect to the spacer material 466. Thus, in some examples, the material compositions of the insulator material 415, the spacer material 466, and the sacrificial material 310 are different. In one such example, the spacer material may include silicon, oxygen, carbon, and nitrogen (e.g., SiOCN), the sacrificial material 310 may include nitrogen (e.g., silicon nitride), and the insulator material 415 may be an oxide (e.g., silicon oxide). In other examples, the semiconductor material 432 may not be replaced by an insulator material.

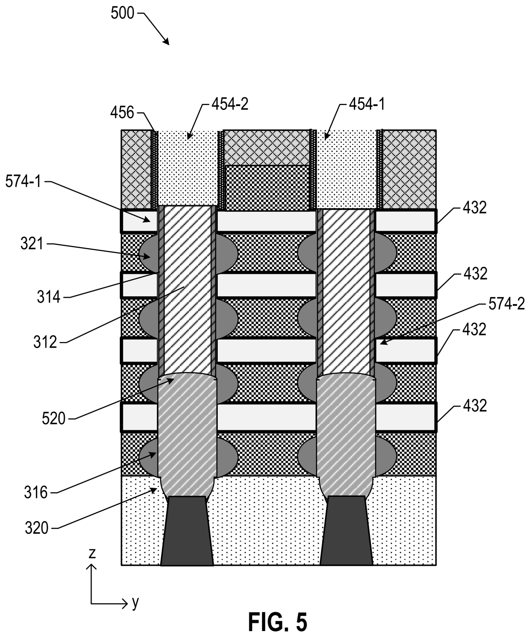

In order to remove the sacrificial material 310, the IC structure 300C may be flipped over to enable processing from the side 447 (e.g., back side) of the IC structure 300C opposite the side 445. The sacrificial material 310 may then be removed using any suitable process, exposing the nucleation layer 314 in the S/D openings. In some examples (discussed in more detail below with respect to FIG. 5), the portion of the nucleation layer 314 exposed in the opening after removing the sacrificial material 310 may also be removed, e.g., with any suitable etching process.

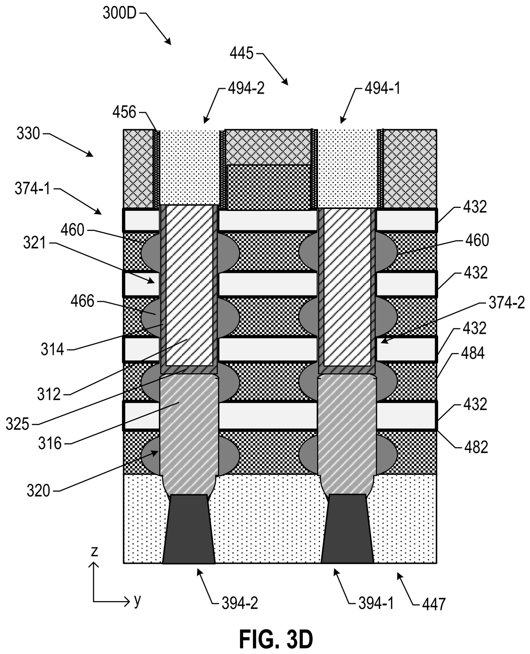

The method 200 continues with a process 208 of providing a second doped semiconductor material in the bottom of the opening from the back side of the IC structure. Providing the second doped semiconductor material may be accomplished with any suitable process, such as an epitaxial deposition process (e.g., epitaxial growth from the bottom of the doped semiconductor material 312 or the nucleation layer 314 below the doped semiconductor material 312). In one such example, the second semiconductor material may be formed with a relatively low temperature epitaxial deposition process (e.g., to prevent damage to previously formed elements of the IC structure 300D). The IC structure 300D of FIG. 3D is an example of an IC structure resulting from the process 208. As can be seen in FIG. 3D, the IC structure 300D includes a second doped semiconductor material 316 at the bottom of the S/D openings. The second doped semiconductor material 316 may have one or more different properties compared to the first doped semiconductor material 312 (e.g., due to the low temperature process used and/or due to the direction of epitaxial growth). In one example, the doped semiconductor material 312 and the doped semiconductor material 316 may have different material compositions, crystal direction/orientation, dopant concentrations, and/or other different properties. In the example illustrated in FIG. 3D, the IC structure also includes backside S/D contacts 394-1, 394-2 below and coupled with the second doped semiconductor material 316. In other examples, only one of the S/D regions 374-1, 374-2 are coupled with a backside contact (e.g., only the source region may have a backside contact, or only the drain region may have a backside contact). In one such example, the techniques described herein may be applied to the S/D region with the backside contact.

Thus, in the example illustrated in FIG. 3D, the IC structure 300D includes a transistor 330 including a channel region in the stack of nanoribbons and S/D regions 374-1, 374-2, where the S/D regions 374-1, 374-2 include a bottom portion 320 including the doped semiconductor material 316 and a top portion 321 including the doped semiconductor material 312. A layer of a third doped semiconductor material (e.g., nucleation layer 314) is on sidewalls of the region 374-1 between the top nanoribbon and the top portion 321, and the third semiconductor material (e.g., nucleation layer 314) is absent from sidewalls between the bottom nanoribbon and the bottom portion 320 (e.g., the nucleation layer is limited to the sidewalls of the top portion 321 of the S/D region 374-1). In one such example, the second doped semiconductor material 316 is in contact (e.g., in direct contact, without an intervening nucleation layer) with the channel portion of the nanoribbons in the bottom portion 320. In the example illustrated in FIG. 3D, a layer 325 of the third doped semiconductor material (e.g., a portion of the nucleation layer 314) is present between the bottom portion 320 and the top portion 321. The absence of the nucleation layer 314 on sidewalls of the channel portions of the nanoribbons and the second doped semiconductor material 316 (and in some examples, the absence of the nucleation layer 314 between the top portion 321 and the bottom portion 320) may enable a significantly lower-resistance conductive path to the bottom nanoribbon(s).

In the example illustrated in FIG. 3D, the second doped semiconductor material 316 is coplanar with the bottom nanoribbon, and the first doped semiconductor material 312 is coplanar with the nanoribbons above the bottom nanoribbon (e.g., the top three nanoribbons shown in FIG. 3D). Therefore, in a cross-section in a plane substantially orthogonal to a device region including the transistor, the region comprises a greater portion of the first semiconductor material 312 than the second semiconductor material 316. In other examples, the proportion of the second semiconductor material 316 and the first semiconductor material 312 in an S/D region 374-1, 374-2 may be about the same, or the S/D regions 374-1, 374-2 may include a greater proportion of the second semiconductor material 316 than the first semiconductor material 312.

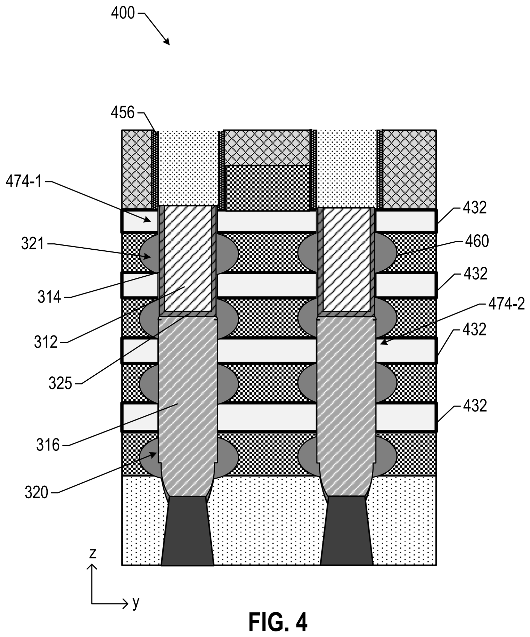

FIG. 4 illustrates a cross-sectional side view of an example IC structure 400 in which the S/D regions 474-1, 474-2 include a greater proportion of the doped semiconductor material grown from the back side. As can be seen in FIG. 4, the second doped semiconductor material 316 is coplanar with the bottom two nanoribbons, and the first doped semiconductor material 312 is coplanar with the top two nanoribbons. In the example illustrated in FIG. 4, in a cross-section in a plane substantially orthogonal to a device region including the transistor, the S/D region 474-1 includes a greater portion of the second semiconductor material 316 than the first semiconductor material 312 (e.g., the second doped semiconductor material 316 occupies more area in the cross-section than the doped semiconductor material 312). Also, in the illustrated example of FIG. 4, the nucleation layer 314 is absent from between the bottom two nanoribbons (e.g., sidewall portions of the bottom two nanoribbons) and the doped semiconductor material 316. In another example, the bottom portion 320 may be coplanar with more than two nanoribbons (e.g., three nanoribbons or four nanoribbons).

FIG. 5 illustrates a cross-sectional side view of another example IC structure 500 fabricated using source/drain engineering techniques for nanoribbon-based transistors. Like the IC structures 300D and 400, the IC structure 500 includes S/D regions 574-1, 574-2 with a top portion 321 and a bottom portion 320, where the bottom portion lacks a nucleation layer on the sidewalls of bottom portion 320 of the S/D regions 574-1, 574-2. The IC structure 500 is an example where the nucleation layer that was originally lining the bottom of the doped semiconductor material 312 has been removed prior to providing the second doped semiconductor material 316 from the back side. Therefore, in the example illustrated in FIG. 5, the first semiconductor material 312 is in contact with the second semiconductor material 316 at an interface 520 between the top portion 321 and the bottom portion 320 (e.g., the nucleation layer 314 is absent between the second doped semiconductor material 316 and the first doped semiconductor material 312).

FIG. 6 illustrates a cross-sectional side view of another example IC structure 600 fabricated using source/drain engineering techniques for nanoribbon-based transistors. In the example illustrated in FIG. 6, the IC structure is similar to the IC structure 300D of FIG. 3D, except the sacrificial material 310 is not removed from the bottom of the S/D openings. Therefore, the sacrificial material 310 is present in the final IC structure, and the S/D regions 674-1, 674-2 are limited to the top portion 321 coplanar with the upper nanoribbons (e.g., the lower nanoribbons coplanar with the sacrificial material 310 may be effectively inactive). In one example, an IC structure may include some transistors in which the sacrificial material 310 is removed and replaced with the second doped semiconductor material 316, and others in which the sacrificial material 310 is not removed.

Such a technique may be useful to enable transistors of different strengths. The strength of a nanoribbon-based transistor may be based on a number of factors. One factor that influences the strength of a nanoribbon-based transistor is the width of the nanoribbon(s), where the width of a nanoribbon is a dimension of the nanoribbon in a plane that is substantially parallel with the nanoribbon and orthogonal to the length of the nanoribbon. For example, a smaller nanoribbon width may result in a weaker transistor, and a larger nanoribbon width may result in a stronger transistor. Another factor that affects nanoribbon-based transistor strength is the number of nanoribbons in the stack. For example, a transistor with channel regions in fewer nanoribbons may be weaker than a transistor with channel regions in more nanoribbons. The techniques described herein may enable controlling the number of active nanoribbons in different transistors to enable implementing CMOS circuits with strong and weak transistors.

One example of a CMOS circuit that typically uses both weak and strong transistors is a static random-access memory (SRAM) circuit, which may be implemented with NMOS pass gate and pull-down transistors and PMOS pull-up transistors. In SRAM circuit design, the pull-down transistors are typically stronger than the pass gate transistors to enable a read access, and the pass gate transistors are typically stronger than the pull-up transistors to enable a write access. Thus, pull-up transistors that are much weaker (e.g., 20-30% weaker) than the pull-down transistors are typically used to ensure read and write stability in the SRAM circuit. Therefore, an SRAM circuit may be implemented using NMOS pull-down and pass gate transistors in nanoribbon stacks in which the sacrificial material 310 has been replaced with the back-side doped semiconductor material 316, and PMOS pull-up transistors in nanoribbon stacks where the sacrificial material 310 has not been removed, resulting in a weaker PMOS transistor.

Thus, in one example, an IC structure may include a first transistor where the S/D region has a top portion 321 and bottom portion 320 like in FIGS. 3D, 4, or 5 (e.g., the sacrificial material 310 has been removed and the second doped semiconductor material 316 has been provided in the S/D openings from the back side), and a second transistor where the S/D region is coplanar with the upper nanoribbons and the sacrificial material 310 (e.g., an insulator material) is coplanar with one or more of the bottom nanoribbons like in FIG. 6. In one such example, the first transistor may be an NMOS transistor and the second transistor may be a PMOS transistor (e.g., the S/D region of the first transistor may include N-type dopants, and the S/D region of the second transistor may include P-type dopants). Note that the weak PMOS transistor is one nonlimiting example, and any of the techniques described herein may apply to either N-type or P-type transistors. Although the examples described herein depict the source/drain engineering techniques being applied to both source and drain regions of a transistor, in other examples, the techniques may be applied to only one S/D region of a transistor (e.g., only the source region). For example, only one of the S/D regions may have a backside contact; in one such example, the techniques described herein may be applied to the S/D region with the backside contact.

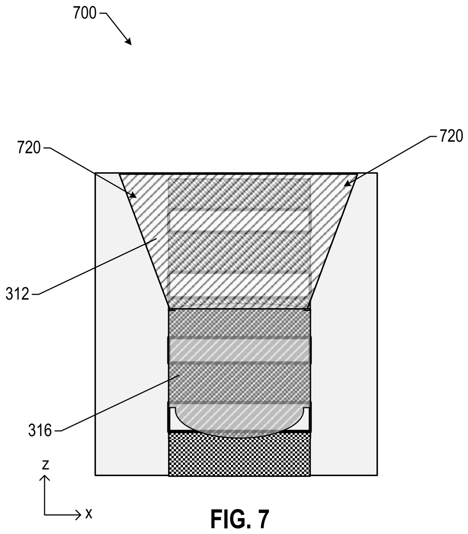

FIG. 7 illustrates another cross-sectional view of an IC structure 700 in the x-z plane (e.g., a "fin cut"). The cross-sectional view shown in FIG. 7 may be an example of the IC structure 400 where the sacrificial material 310 is initially coplanar with the bottom two nanoribbons so that the doped semiconductor material 312 provided from the front side is grown from a nucleation layer on sidewalls of the top two nanoribbons. In a conventional nanoribbon-based transistor, the portions of the doped semiconductor material of the S/D regions may protrude laterally away from the nanoribbon stack, and in some cases may cause S/D region-to-S/D region shorts. In some examples, the techniques described herein may enable better control of the extent to which portions of the S/D regions protrude away from the nanoribbon stack. In some examples, the shape of the protruding portions may also be different when using the S/D engineering techniques described herein compared to conventional techniques. As can be seen in FIG. 7, the portions 720 of the doped semiconductor material 312 protrude or extend away from the upper nanoribbons of the nanoribbon stack, and the greatest width of the portions 720 may be in the vicinity of the top nanoribbon (in the illustrated example, the widest portion of the doped semiconductor material 312 that protrudes away from the stack may be above the top nanoribbon, where the width of the protruding portions 720 is a dimension of the portions 720 in a plane substantially parallel with the device region, e.g., along the x-axis shown in FIG. 7). In the example illustrated in FIG. 7, the second doped semiconductor material 316 may not protrude significantly away from the nanoribbon stack. For example, the width of the second doped semiconductor material 316 in the cross-section shown in FIG. 7 is about the same as or smaller than the widths of the doped semiconductor material 312. Thus, the size and shape of the portions 720 of the doped semiconductor material 312 of the S/D regions may be different when using S/D engineering techniques as described herein.

Accordingly, IC structures fabricated using source/drain engineering techniques for nanoribbon-based transistors can reduce resistance between bottom nanoribbon(s) and S/D regions to increase device drive and performance.

IC structures fabricated using source/drain engineering techniques for nanoribbon-based transistors as described herein (e.g., as described with reference to FIGS. 1, 2, 3A-3D, and 4-7) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 100, 300D, 400, 500, 600, and 700, may be included in any suitable electronic component. FIGS. 8-12 illustrate various examples of apparatuses that may include the IC structures 100, 300D, 400, 500, 600, and 700 disclosed herein.

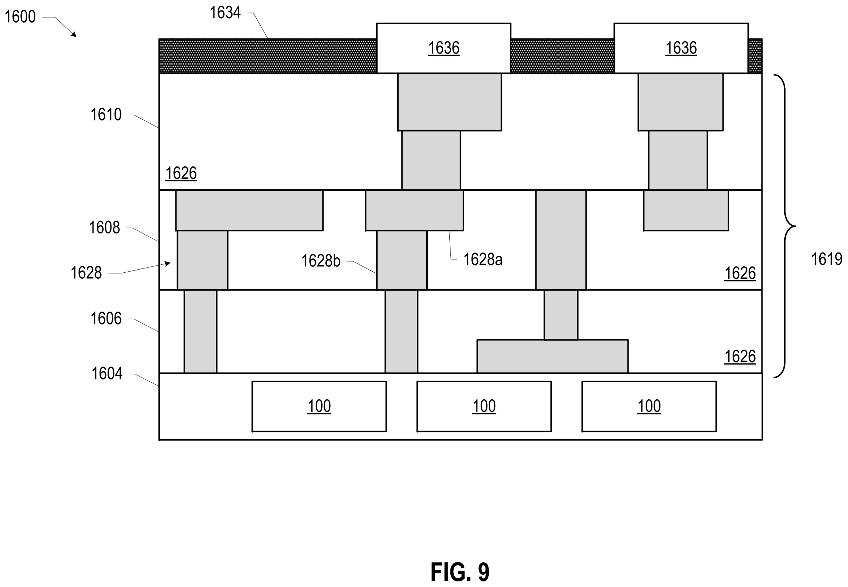

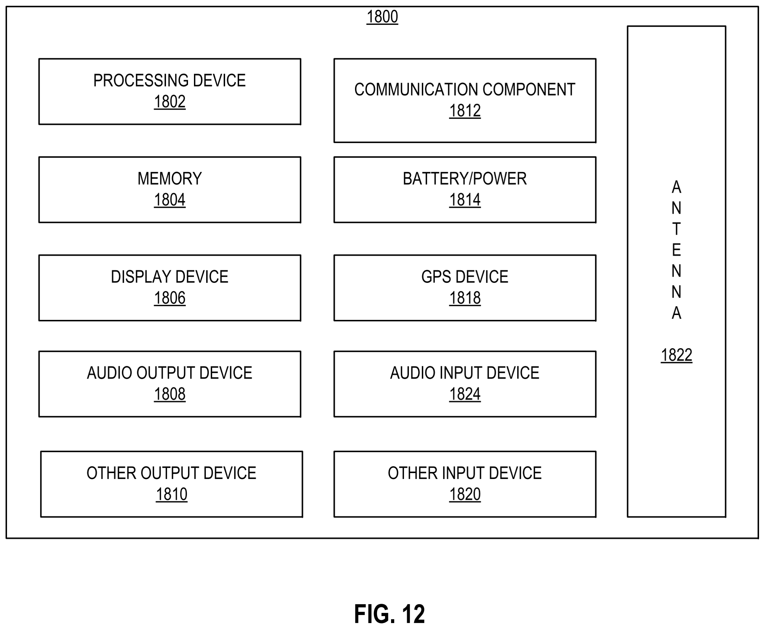

FIG. 8 is a top view of a wafer 1500 and dies 1502 that may include one or more IC structures 100, 300D, 400, 500, 600, and 700 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100, 300D, 400, 500, 600, and 700 (e.g., as discussed below with reference to FIG. 9), one or more transistors (e.g., some of the transistors of the device region 1604 of FIG. 9, discussed below, e.g., nanoribbon-based transistors of the IC structures 100, 300D, 400, 500, 600, and 700) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductivebridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 12) or other logic that is configured to store information in the memory devices or execute instructions stored in the memory array.

FIG. 9 is a side, cross-sectional view of an IC device 1600 that may include one or more IC structures in accordance with any of the embodiments disclosed herein (e.g., in accordance with IC structures 100, 300D, 400, 500, 600, and 700). One or more of the IC devices 1600 may be included in one or more dies 1502 (FIG. 8). The IC device 1600 may include a device region 1604 including one or more IC structures (e.g., one or more of IC structures 100, 300D, 400, 500, 600, and 700) disclosed herein, or any variations of the IC structures. The device region 1604 may further include electrical contacts to the gates of the transistors included in the device region 1604 and to the S/D materials of the transistors included in the device region 1604 (e.g., to the S/D regions 114-1, 114-2 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 9 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 9). Although a particular number of interconnect layers 1606-1610 is depicted in FIG. 9, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 9. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 9. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114-1, 114-2 or gate of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 9, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

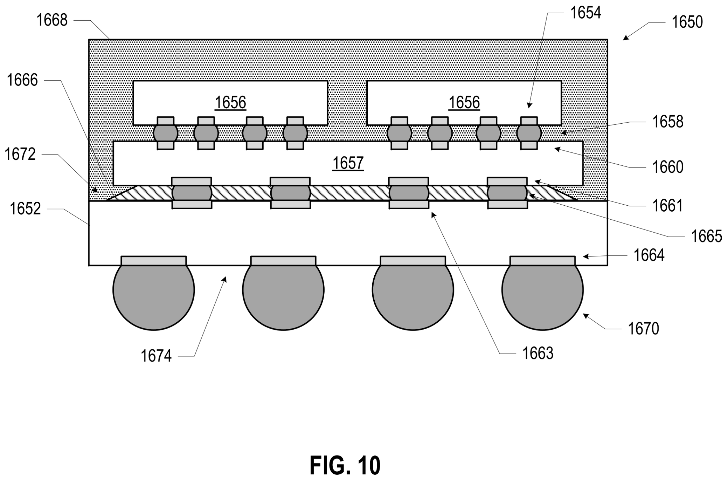

FIG. 10 is a side, cross-sectional view of an example IC package 1650 that may include one or more IC structures 100, 300D, 400, 500, 600, and 700 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnect structures 1628 discussed above with reference to FIG. 9.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 10 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 10 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

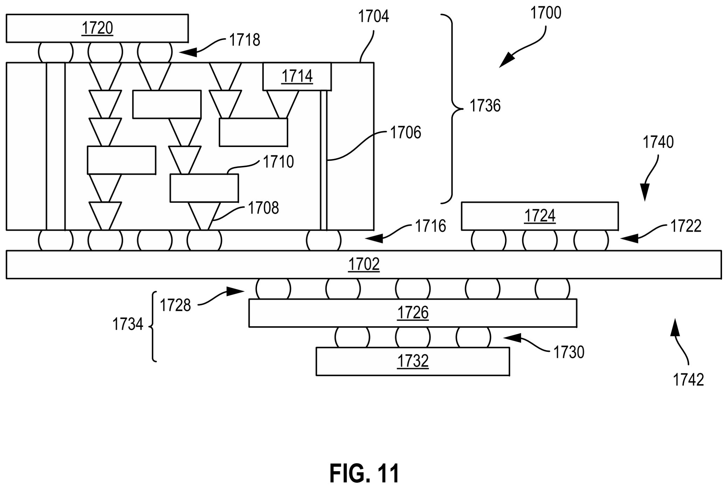

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 10 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 11.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 10 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 10, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 11 is a side, cross-sectional view of an IC device assembly 1700 that may include one or more IC packages or other electronic components (e.g., a die) including one or more IC structures 100, 300D, 400, 500, 600, and 700 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 10 (e.g., may include one or more IC structures 100, 300D, 400, 500, 600, and 700).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 11 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 11), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 11, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 8), an IC device (e.g., the IC device 1600 of FIG. 9), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 11, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 11 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 12 is a block diagram of an example electrical device 1800 that may include one or more IC structures 100, 300D, 400, 500, 600, and 700 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 12 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 12, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a stack of two or more nanoribbons stacked over one another, where the two or more nanoribbons include a first nanoribbon and a second nanoribbon below the first nanoribbon; a region in the stack, where: the region is either a source region or a drain region of a transistor, the region includes a first portion coplanar with the first nanoribbon and a second portion coplanar with the second nanoribbon, the first portion includes a first doped semiconductor material and the second portion includes a second doped semiconductor material, a layer of a third doped semiconductor material (e.g., nucleation layer) is on sidewalls of the region between the first nanoribbon and the first portion, and the layer is limited to the sidewalls of the first portion of the region (e.g., the nucleation layer is absent on sidewalls of the second portion of the region); a first contact structure over and coupled with the first portion; and a second contact structure below and coupled with the second portion.

Example 2 provides the IC structure of example 1, where: the third doped semiconductor material (e.g., the nucleation layer) has a lower dopant concentration than the second doped semiconductor material (and lower than the first doped semiconductor material, e.g., the dopant concentration in the nucleation layer is lower than in both the first and second portions).

Example 3 provides the IC structure of any one of examples 1-2, where the layer is a first layer, and where the IC structure further includes a second layer of the third doped semiconductor material between the first portion and the second portion (e.g., a nucleation layer is between the first portion and the second portion).

Example 4 provides the IC structure of any one of examples 1-2, where: the first semiconductor material (e.g., of the first portion) is in contact with the second semiconductor material (e.g., of the second portion) at an interface between the first portion and the second portion (e.g., the nucleation layer is absent between the first portion and the second portion).

Example 5 provides the IC structure of any one of examples 1-4, where: the stack further includes a third nanoribbon between the first nanoribbon and the second nanoribbon, where the third nanoribbon is coplanar with the second portion (e.g., second portion is coplanar with at least two bottom nanoribbons).

Example 6 provides the IC structure of any one of examples 1-5, where: in a cross-section in a plane substantially orthogonal to a device region including the transistor, the region includes a greater portion of the first semiconductor material than the second semiconductor material.

Example 7 provides the IC structure of any one of examples 1-5, where: in a cross-section in a plane substantially orthogonal to a device region including the transistor, the region includes a greater portion of the second semiconductor material than the first semiconductor.

Example 8 provides the IC structure of any one of examples 1-7, where: in a cross-section in a plane substantially orthogonal to a device region including the transistor and orthogonal to a length of the first nanoribbon (e.g., in a fin-cut): the first doped semiconductor material (e.g., of the first portion) has a first width coplanar with a top nanoribbon of the stack and a second width coplanar with another nanoribbon of the stack that is below the top nanoribbon and above a bottom nanoribbon of the stack, where the first width is greater than the second width.

Example 9 provides the IC structure of example 8, where: in a cross-section in the plane: the second doped semiconductor material (e.g., of the second portion) has a third width that is smaller than the first width.

Example 10 provides the IC structure of any one of examples 1-9, where: the first doped semiconductor material (e.g., of the first portion) has a first crystal direction, and the second doped semiconductor material (e.g., of the second portion) has a second crystal direction that is different from the first crystal direction.

Example 11 provides the IC structure of any one of examples 1-10, where: the first doped semiconductor material has a different material composition from the second doped semiconductor material.

Example 12 provides an IC structure, including a stack of nanoribbons of a semiconductor material; and a transistor including a channel region in the stack of nanoribbons and a region that is either a source region or a drain region of the transistor, where: the region includes a bottom portion coplanar with a bottom nanoribbon of the stack and a second top portion coplanar with a top nanoribbon of the stack, the bottom portion includes a first doped semiconductor material and the top portion includes a second doped semiconductor material, a layer of a third doped semiconductor material (e.g., nucleation layer) is on sidewalls of the region between the top nanoribbon and the top portion, and the layer is limited to the sidewalls of the top portion of the region (i.e., the nucleation layer is absent on sidewalls of the backside epi).

Example 13 provides the IC structure of example 12, where the transistor is a first transistor, the channel region is a first channel region, the stack is a first stack, the region is a first region, the source region is a first source region, the drain region is a first drain region, the bottom portion is a first bottom portion, the top portion is a first top portion, and where the IC structure further includes a second stack of nanoribbons parallel and coplanar with the first stack; and a second transistor including a second channel region in the second stack of nanoribbons and a second region that is either a second source region or a second drain region of the second transistor, where: the second region is coplanar with the top portion of the first region (e.g., the S/D region of the second transistor may be coplanar with the top portion of the S/D region of the first transistor), and an insulator material is coplanar with the bottom portion of the first region and coplanar with the bottom nanoribbon (e.g., there may be a portion of the insulator material remaining at the bottom of the S/D opening of the second transistor).

Example 14 provides the IC structure of example 13, where: the first region includes N-type dopants, and the second region includes P-type dopants (e.g., the second transistor may be a weaker PMOS transistor).

Example 15 provides the IC structure of any one of examples 12-14, where: the third doped semiconductor material (e.g., the nucleation layer) has a lower dopant concentration than the second doped semiconductor material.

Example 16 provides the IC structure of any one of examples 12-15, where the layer is a first layer, and where the IC structure further includes a second layer of the third doped semiconductor material between the top portion and the bottom portion.

Example 17 provides the IC structure of any one of examples 12-15, where: the first semiconductor material is in contact with the second semiconductor material at an interface between the top portion and the bottom portion (e.g., the nucleation layer may be absent between the top and bottom portions).

Example 18 provides the IC structure of any one of examples 12-17, where: the stack includes another nanoribbon between the top nanoribbon and the bottom nanoribbon, where the other nanoribbon is coplanar with the bottom portion.

Example 19 provides an IC structure according to any one of examples 1-18, where the IC structure includes or is a part of a central processing unit.

Example 20 provides an IC structure according to any one of examples 1-19, where the IC structure includes or is a part of a memory device.

Example 21 provides an IC structure according to any one of examples 1-20, where the IC structure includes or is a part of a logic circuit.

Example 22 provides an IC structure according to any one of examples 1-21, where the IC structure includes or is a part of input/output circuitry.

Example 23 provides an IC structure according to any one of examples 1-22, where the IC structure includes or is a part of a field programmable gate array transceiver.

Example 24 provides an IC structure according to any one of examples 1-23, where the IC structure includes or is a part of a field programmable gate array logic.

Example 25 provides an IC structure according to any one of examples 1-24, where the IC structure includes or is a part of a power delivery circuitry.

Example 26 provides an IC package that includes an IC die including an IC structure according to any one of examples 1-25; and a further IC component, coupled to the IC die.

Example 27 provides an IC package according to example 26 where the further IC component includes a package substrate.

Example 28 provides an IC package according to example 26, where the further IC component includes an interposer.

Example 29 provides an IC package according to example 26, where the further IC component includes a further IC die.

Example 30 provides a computing device that includes a carrier substrate and an IC structure coupled to the carrier substrate, where the IC structure is an IC structure according to any one of examples 1-25, or the IC structure is included in the IC package according to any one of examples 26-29.

Example 31 provides a computing device according to example 30, where the computing device is a wearable or handheld computing device.

Example 32 provides a computing device according to examples 30 or 31, where the computing device further includes one or more communication chips.

Example 33 provides a computing device according to any one of examples 30-32, where the computing device further includes an antenna.

Example 34 provides a computing device according to any one of examples 30-33, where the carrier substrate is a motherboard.

Example 35 provides a process of making an IC structure, including forming an opening in a stack of nanoribbons from a first side of the IC structure (e.g., from the front side); providing a sacrificial material at a bottom of the opening; providing a first doped semiconductor material in the opening over the sacrificial material; removing the sacrificial material from a second side of the IC structure that is opposite the first side; and providing a second doped semiconductor material from the second side of the IC structure.

Example 36 provides the process of example 35, where: providing the sacrificial material at the bottom of the opening includes providing an insulator material in the opening coplanar with a bottom nanoribbon of the stack.

Example 37 provides a method according to any one of examples 35-36, where the IC structure is an IC structure according to any one of the preceding examples.

Example 38 provides a process of making an IC structure according to the method of any one of examples 35-37.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a stack of two or more nanoribbons stacked over one another, wherein the two or more nanoribbons comprise a first nanoribbon and a second nanoribbon below the first nanoribbon;
a region in the stack, wherein:
the region is either a source region or a drain region of a transistor,
the region comprises a first portion coplanar with the first nanoribbon and a second portion coplanar with the second nanoribbon,
the first portion comprises a first doped semiconductor material and the second portion comprises a second doped semiconductor material,
a layer of a third doped semiconductor material is on sidewalls of the region between the first nanoribbon and the first portion, and
the layer is limited to the sidewalls of the first portion of the region; and
a contact structure below and coupled with the second portion.

2. The IC structure of claim 1, wherein:
the third doped semiconductor material has a lower dopant concentration than the second doped semiconductor material.

3. The IC structure of claims 1 or 2, wherein the layer is a first layer, and wherein the IC structure further comprises:
a second layer of the third doped semiconductor material between the first portion and the second portion.

4. The IC structure of claims 1 or 2, wherein:
the first semiconductor material is in contact with the second semiconductor material at an interface between the first portion and the second portion.

5. The IC structure of any one of claims 1-4, wherein:
the stack further comprises a third nanoribbon between the first nanoribbon and the second nanoribbon, wherein the third nanoribbon is coplanar with the second portion.

6. The IC structure of any one of claims 1-5, wherein:
in a cross-section in a plane substantially orthogonal to a device region comprising the transistor, the region comprises a greater portion of the first semiconductor material than the second semiconductor material.

7. The IC structure of any one of claims 1-5, wherein:
in a cross-section in a plane substantially orthogonal to a device region comprising the transistor, the region comprises a greater portion of the second semiconductor material than the first semiconductor material.

8. The IC structure of any one of claims 1-7, wherein:
in a cross-section in a plane substantially orthogonal to a device region comprising the transistor and orthogonal to a length of the first nanoribbon:
the first doped semiconductor material has a first width coplanar with a top nanoribbon of the stack and a second width coplanar with another nanoribbon of the stack that is below the top nanoribbon and above a bottom nanoribbon of the stack, wherein the first width is greater than the second width.

9. The IC structure of claim 8, wherein:
in the cross-section in the plane:
the second doped semiconductor material has a third width that is smaller than the first width.

10. The IC structure of any one of claims 1-9, wherein:
the first doped semiconductor material has a first crystal direction, and
the second doped semiconductor material has a second crystal direction that is different from the first crystal direction.

11. The IC structure of any one of claims 1-10, wherein:
the first doped semiconductor material has a different material composition from the second doped semiconductor material.

12. The IC structure of any one of claims 1-11, wherein the contact structure is a first contact structure, and wherein the IC structure further comprises:
a second contact structure over and coupled with the first portion.

13. The IC structure of any one of claims 1-4 and 6-12, wherein:
the stack further comprises a third nanoribbon and a fourth nanoribbon between the first nanoribbon and the second nanoribbon, wherein:
the third nanoribbon is coplanar with the first portion, and
the fourth nanoribbon is coplanar with the second portion.

14. The IC structure of any one of claims 1-13, wherein the stack is a first stack, the region is a first region, and wherein the IC structure further comprises:
a first transistor comprising a first channel region in the first stack, wherein the first region is a first source or first drain region of the first transistor;
a second stack of nanoribbons parallel and coplanar with the first stack; and
a second transistor comprising a second channel region in the second stack and a second region that is either a second source region or a second drain region of the second transistor, wherein:
the second region is coplanar with the first portion of the first region, and
an insulator material is coplanar with the second portion of the first region.

15. The IC structure of claim 14, wherein:
the first region comprises N-type dopants, and
the second region comprises P-type dopants.
